Europäisches Patentamt

(19) European Patent Office

Office européen des brevets

(11) Publication number: **0 193 331 B1**

## (12) EUROPEAN PATENT SPECIFICATION

(45) Date of publication of patent specification :
27.02.91 Bulletin 91/09

(51) Int. Cl.⁵ : **H01L 21/321, H01L 21/268**

(21) Application number : **86301097.1**

(22) Date of filing : **18.02.86**

(54) Process for forming a doped polysilicon pattern.

(30) Priority : 23.02.85 GB 8504725

(43) Date of publication of application :
03.09.86 Bulletin 86/36

(45) Publication of the grant of the patent :
27.02.91 Bulletin 91/09

(84) Designated Contracting States :
AT BE CH DE FR IT LI LU NL SE

(56) References cited :
GB-A- 2 130 009
GB-A- 2 143 083
US-A- 4 214 918
PATENT ABSTRACTS OF JAPAN, vol. 8, no. 84
(E-239)[[1521], 18th April 1984; & JP-A-59 5633
(SUWA SEIKOSHA K.K.) 12-01-1984
JOURNAL OF THE ELECTROCHEMICAL SOCI-
ETY, vol. 130, no. 11, November 1983, pages
2271-2274, Manchester, New Hampshire, US;
K. TAKEBAYASHI et al.: "Infrared radiation
annealing of ion-implanted polycrystalline sili-
con using a graphite heater"
SOLID STATE TECHNOLOGY, vol. 24, no. 6,
June 1981, pages 88-94, Port Washington, New
York, US; Y. AKASAKA et al.: "CW laser anne-
aling of ion implanted or doped polycrystalline
silicon"
EXTENDED ABSTRACTS, vol. 84, no. 2, 1984,
pages 760-761, abstract no. 519, New Orleans,
Louisiana, US; H. NISHIMURA et al.: "A rapid
isothermal annealing for a VLSI interconnec-
tion technology"
EXTENDED ABSTRACTS, vol. 82-2, October
1982, pages 348-349, Pennington, New Jersey,
US: S. IWAMATSU et al.: "Application of halo-
gen lamp annealing for CMOS VLSI proces-
sing"
JAPANESE JOURNAL OF APPLIED PHYSICS,
vol. 23, no. 10, October 1984, pages L761-L764,
Tokyo, JP; Z.M. CHEN et al.: "A comparative
study on the electrical properties of amorph-
ous silicon thin films in light-induced crystal-
lization"

(56) References cited :
JOURNAL OF THE ELECTROCHEMICAL SOCI-
ETY, vol. 130, no. 2, February 1983, pages
484-493, Manchester, New Hampshire, US;
T.O. SEDGWICK: "Short time annealing"

(73) Proprietor : STC PLC
10, Maltravers Street
London, WC2R 3HA (GB)

(72) Inventor : Scovell, Peter Denis
14 Staplecroft Spring Field
Chelmsford Essex (GB)
Inventor : Baker, Roger Leslie
7 Third Avenue
Chelmsford Essex (GB)

## Description

This invention relates to integrated circuits, and in particular to the provision of polysilicon conductors on such circuits.

Polycrystalline silicon, or polysilicon, is frequently used in the fabrication of conductive regions, e.g. gates and interconnection tracks, on integrated circuits. Its use, particularly in high frequency applications, is however limited by the relatively high resistivity of the material. Attempts have been made to overcome this problem by doping the polysilicon typically with phosphorus, arsenic or boron. It is then necessary to anneal the material to diffuse the dopant thereby achieving the desired low resistivity.

It has been found that, using conventional furnace annealing techniques, much of the dopant is trapped in the grain boundaries of the polysilicon and is therefore inactive. Furthermore, during the annealing process, redistribution of the dopants in underlying active areas can occur. This is clearly particularly undesirable when the circuit comprises small devices at a high integration density.

The object of the present invention is to minimise or to overcome this disadvantage.

According to one aspect of the invention there is provided a process for forming a doped polycrystalline silicon (polysilicon) interconnection pattern disposed on an insulating layer in a bipolar/MOS integrated circuit formed on a silicon substrate, the process including the steps of :

providing an insulating layer of silica or silicon nitride on said circuit ;

providing an amorphous silicon patterned layer on said insulating layer, said amorphous silicon layer having a dopant concentration of 0.3 to 3 atomic percent ;

heating the structure to a temperature of 500 to 900°C whereby to effect crystallisation of the doped amorphous silicon to polysilicon ;

and further heating the structure to a temperature of 1000 to 1100°C for a period of 0.5 to 5 seconds whereby to activate said dopant and reduce the resistivity of the polysilicon.

As the high temperature excursion requires only a short period of time the risk of dopant redistribution in the circuit is substantially eliminated.

An embodiment of the invention will now be described with reference to the accompanying drawings in which

Fig. 1 is a cross-sectional view of an integrated circuit provided with a silicon conductor pattern,

and Fig. 2 illustrates the relationship between doped polysilicon sheet resistance and anneal time.

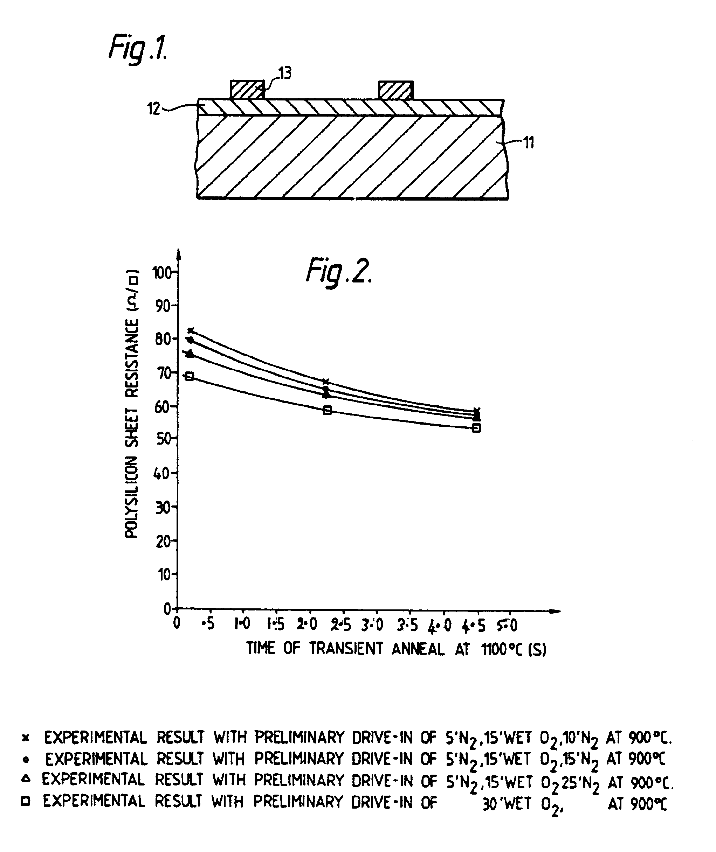

Referring to the Fig. 1, a semiconductor substrate 11 incorporating a plurality of active devices (not shown) is provided with an insulating layer 12 of a refractory material, e.g. silica or silicon nitride. The insulating layer is in turn coated with a patterned layer 13 of doped polycrystalline silicon. Typically the assembly comprises a merged technology circuit in which a number of both CMOS and bipolar devices are provided on a common substrate. The polysilicon layer 13 may thus provide an interconnection pattern, the CMOS gates, and bipolar polysilicon emitters. Such a structure is described in our copending UK application No. 8507624. The resistivity of the polysilicon 13 is reduced by effecting reactivation of the dopant. This is performed by pulse heating the assembly to a temperature at which reactivation occurs. As this thermal treatment is relatively short there is no significant effect on circuit devices formed in the substrate 11.

In a typical process an integrated circuit is provided with a doped polysilicon conductor pattern formed from an amorphous silicon layer. Such a layer may be deposited by LPCVD (low pressure chemical vapour deposition), PECVD (plasma enhanced chemical vapour deposition) or reactive sputtering. The amorphous silicon is doped, e.g. with phosphorus, arsenic or boron. Doping can be effected chemically during growth or subsequently by ion implantation. The assembly is then heated to a temperature of 500 to 1000°C to recrystallise the material to form polysilicon. At the relatively low temperatures employed to effect this recrystallisation substantially no dopant redistribution occurs in the integrated circuit. Typically the dopant comprises 0.3 to 3 At % of the amorphous silicon.

During this recrystallisation of the amorphous silicon most of the dopants are trapped in non-substitutional sites in the growing crystals and are thus electrically inactive. The dopant is fully activated by a short high temperature excursion to e.g. 1000 to 1110°C for 0.5 to 5 seconds in a transient annealing apparatus. We have found that the use of transient annealing to activate the dopants minimises segregation to grain boundaries and thus provides a high dopant activity and a low resistivity. Typically the final resistivity is from 2 to 15 m ohm cm.

Masking and etching of the silicon layer to define the desired conductor pattern may be performed at a convenient stage in the process. Typically, etching is effected after crystallisation but before dopant activation.

In an alternative process the silicon layer 13 may be deposited as a doped or undoped material.Where undoped material is used, doping may be effected by ion implantation.

In a typical example we have formed in situ phosphorus doped amorphous silicon films containing 0.3 At % of dopant. These were found to have a resistivity of 25 m ohm cm. The films were annealed at 850°C for 50 minutes to recrystallise the silicon and then had a measured resistivity of 20 m ohm cm. Pulse annealing of the films for 1 second at 1100°C using incoherent radiation provided a final resistivity of 14 m ohm cm. Similarly treated films containing 2.5 At % phosphorus had a measured resistivity of 6.2 m ohm cm after annealing for 1 second at 1000°C compared with 30 m ohm cm prior to recrystallisation.

The relationship between annealing time and sheet resistance is illustrated in Fig. 2 of the accompanying drawings. Measurements have been made on four silicon films each of 4300A (430nm) thickness. In each case the material was implanted with arsenic at 40 keV with a dose of 1.5E16 $cm^{-2}$ followed by a preliminary drive in at 900°C. The final sheet resistances observed correspond to resistivities in the range 2.4 to 3.65 m ohm cm.

The use of transient annealing for dopant activation together with low regrowth temperatures is particularly suited to the low temperature process requirements for advanced CMOS and bipolar circuits. It is not however limited to these particular processes and has general semiconductor application.

## Claims

1. A process for forming a doped polycrystalline silicon (polysilicon) interconnetion pattern disposed on an insulating layer in a bipolar/MOS integrated circuit formed on a silicon substrate, the process including the steps of :

providing an insulating layer of silica or silicon nitride on said circuit ;

providing an amorphous silicon patterned layer on said insulating layer, said amorphous silicon layer having a dopant concentration of 0.3 to 3 atomic percent ;

annealing the structure at a temperature of 500 to 900°C whereby to effect crystallisation of the doped amorphous silicon to polysilicon ;

and further pulse heating the structure to a temperature of 1000 to 1100°C for a period of 0.5 to 5 seconds whereby to activate said dopant and reduce the resistivity of the polysilicon.

2. A process as claimed in claim 1, characterised in that crystallisation of the amorphous silicon is effected by annealing the amorphous silicon at a temperature of 850°C for a period of 50 minutes.

3. A process as claimed in claim 1 or 2 characterised in that the dopant activation is effected by heating the polysilicon film to a temperature of 1100°C for a period of 1 second.

4. A process as claimed in claim 1, 2 or 3, characterised in that the dopant is phosphous, arsenic or boron.

5. A process as claimed in any one of claims 1 to 4, characterised in that the resistivity of the polysilicon conductive layer is from 2 to 15 m ohm cm.

6. A process as claimed in any one of claims 1 to 5 characterised in that the doped polysilicon layer provides the gates of the CMOS devices, the emitters of the bipolar devices and an interconnect pattern.

## Ansprüche

1. Verfahren zur Herstellung eines Verbindungsmusters aus dotiertem polykristallinem Silizium (Polysilizium), das auf einer Isolierschicht in einer integrierten Bipolar/MOS-Schaltung angeordnet ist, die auf einem Siliziumsubstrat ausgebildet ist, wobei das Verfahren die folgenden Schritte umfaßt :

Herstellung einer Isolierschicht aus Silika oder Siliziumnitrid auf der Schaltung,

Ausbildung einer mit einem Muster versehenen amorphen Siliziumschicht auf der Isolierschicht, wobei die amorphe Siliziumschicht eine Dotierungskonzentration von 0,3 bis 3 Atomprozent aufweist,

Tempern der Struktur bei einer Temperatur von 500 bis 900°C, wodurch eine Kristallisierung des dotierten amorphen Siliziums zu Polysilizium bewirkt wird,

und weiteres impulsförmiges Erwärmen der Struktur auf eine Temperatur von 1000 bis 1100 °C für eine Zeitperiode von 0,5 bis 5 Sekunden, wodurch das Dotierungsmittel aktiviert und der spezifische Widerstand des Polysiliziums verringert wird.

2. Verfahren nach Anspruch 1, dadurch **gekennzeichnet**, daß die Kristallisierung des amorphen Siliziums durch Tempern des amorphen Siliziums bei einer Temperatur von 850°C für eine Zeitperiode von 50 Minuten bewirkt wird.

3. Verfahren nach Anspruch 1 oder 2, dadurch **gekennzeichnet**, daß die Dotierungsaktivierung durch Erwärmen des Polysiliziumfilms auf eine Temperatur von 1100°C für eine Zeitperiode von einer Sekunde bewirkt wird.

4. Verfahren nach Anspruch 1, 2 oder 3, dadurch **gekennzeichnet**, daß das Dotierungsmittel Phosphor, Arsen oder Bor ist.

5. Verfahren nach einem der Ansprüche 1 bis 4, dadurch **gekennzeichnet**, daß der spezifische Widerstand der leitenden Polysiliziumschicht zwischen 2 und 15 m Ohm cm liegt.

6. Verfahren nach einem der Ansprüche 1 bis 5, dadurch **gekennzeichnet**, daß die dotierte Polysiliziumschicht die Gates der CMOS-Bauteile, die Emitter der bipolaren Bauteile und ein Verbindungsmuster bildet.

## Revendications

1. Procédé de formation d'un dessin d'interconnexion de silicium polycristallin dopé disposé sur une couche isolante dans un circuit intégré bipolaire-MOS formé sur un substrat de silicium, le procédé comprenant les étapes suivantes :

la disposition d'une couche isolante de silice ou de nitrure de silicium sur le circuit,

la disposition d'une couche de silicium amorphe formant un dessin sur la couche isolante, la couche de silicium amorphe ayant une concentration de matière de dopage comprise entre 0,3 et 3 atomes %,

le recuit de la structure à une température comprise entre 500 et 900 °C afin que la recristallisation du silicium amorphe dopé en silicium polycristallin soit réalisée, puis

le chauffage pulsé de la structure à une température comprise entre 1000 et 1100 °C pendant une période comprise entre 0,5 et 5 s afin que la matière de dopage soit activée et que la résistivité du silicium polycristallin soit réduite.

2. Procédé selon la revendication 1, caractérisé en ce que la cristallisation du silicium amorphe est réalisée par recuit du silicium amorphe à une température de 850 °C pendant une période de 50 min.

3. Procédé selon la revendication 1 ou 2, caractérisé en ce que l'activation de la matière de dopage est réalisée par chauffage du film de silicium polycristallin à une température de 1100 °C pendant une période de 1 s.

4. Procédé selon la revendication 1, 2 ou 3, caractérisé en ce que la matière de dopage est le phosphore, l'arsenic ou le bore.

5. Procédé selon l'une quelconque des revendications 1 à 4, caractérisé en ce que la résistivité de la couche conductrice de silicium polycristallin est comprise entre 2 et 15 mΩ. cm.

6. Procédé selon l'une quelconque des revendications 1 à 5, caractérisé en ce que la couche de silicium polycristallin dopé constitue les grilles des dispositifs CMOS, les émetteurs des dispositifs bipolaires et un dessin d'interconnexion.

## Fig.1.

## Fig.2.

TIME OF TRANSIENT ANNEAL AT 1100°C (S)

× EXPERIMENTAL RESULT WITH PRELIMINARY DRIVE-IN OF 5'$N_2$,15'WET $O_2$,10'$N_2$ AT 900°C.

● EXPERIMENTAL RESULT WITH PRELIMINARY DRIVE-IN OF 5'$N_2$,15'WET $O_2$,15'$N_2$ AT 900°C

△ EXPERIMENTAL RESULT WITH PRELIMINARY DRIVE-IN OF 5'$N_2$,15'WET $O_2$25'$N_2$ AT 900°C.

□ EXPERIMENTAL RESULT WITH PRELIMINARY DRIVE-IN OF       30'WET $O_2$,       AT 900°C